Europäisches Patentamt

(19) European Patent Office

Office européen des brevets

(11) Publication number: **0 068 600**
**B1**

(12) **EUROPEAN PATENT SPECIFICATION**

(45) Date of publication of patent specification: **11.06.86**

(21) Application number: **82301362.8**

(22) Date of filing: **17.03.82**

(51) Int. Cl.⁴: **H 01 J 1/88, H 01 J 29/82**

(54) **A method of forming an aligned assembly of a plurality of planar members and an aligned assembly produced thereby.**

(30) Priority: **26.06.81 US 277554**

(43) Date of publication of application:
**05.01.83 Bulletin 83/01**

(45) Publication of the grant of the patent:
**11.06.86 Bulletin 86/24**

(84) Designated Contracting States:
**DE FR GB**

(56) References cited:
**FR-A-2 441 266**

**IBM TECHNICAL DISCLOSURE BULLETIN, vol. 19, no. 8, January 1977, pages 3066-3067, Armonk, New York, USA W.R. EAMES et al.: "Gas display panel spacer rod grooves"**

(73) Proprietor: **CONTROL DATA CORPORATION**
**8100-34th Avenue South**
**Minneapolis Minnesota 55440 (US)**

(72) Inventor: **Walker, David Malcolm**
**2c Pierce Avenue**
**Westford Massachusetts 01886 (US)**
Inventor: **Carrona, John Joseph**
**53 Temple Road**
**Concord Massachusetts 01742 (US)**

(74) Representative: **Caro, William Egerton et al**
**J. MILLER & CO. Lincoln House 296-302 High Holborn**
**London WC1V 7JH (GB)**

Courier Press, Leamington Spa, England.

## Description

This invention relates to methods of forming aligned assemblies of a plurality of planar members and to aligned assemblies of planar members, for example, for electron beam lens and deflector guns.

Conventionally an electron beam lens and deflector gun has two parallel plate sub-assemblies, one consisting of a plurality of lens plates and the other of two fine deflector plates. The lens plates have a grid of apertures, and each deflector plate consists of a set of parallel conductive blades. The blades of one deflector plate are oriented orthogonally to the other deflector plate. The lens plates are commonly composed of silicon while the deflector plates are composed of an electrically conductive material.

The lens plates and deflector plates have to be precisely aligned and to accomplish this it is known to use an optical alignment technique with glass rodding and mechanical referencing to supporting rings as a means to axially align, space and fasten together the components of the sub-assemblies. This technique requires considerable precision opto-mechanical fixing and an elaborate supporting superstructure or cage to hold the sub-assemblies in position.

For electron beam array lithography, the array of the lens and deflector plates has an outside nominal dimension of approximately 2.54 cm (1 inch). In this environment, opto-mechanical fixing becomes prohibitively difficult due to the lack of space on the perimeter of the lens and deflector plates. It is similarly prohibitively difficult to incorporate a supporting superstructure in the limited space available surrounding the array.

In a gas display panel seal rods are placed adjacent the periphery of a front plate and spacer rods are located within the periphery so that the softer seal rods will melt allowing a back plate to collapse until it abuts the spacer rods. IBM Technical Disclosure Bulletin Vo. 19, No. 8 (1977), pages 3066/3067 suggests grooving a dielectric glass on the front plate to conform as closely as possible to the shape of the spacer rod. The grooving grasps the spacer rod so that it cannot be accidentally moved.

According to one aspect of the present invention there is provided a method of forming an aligned assembly of a plurality of planar members comprising the steps of: forming on a first surface of a first of said planar members two pairs of slots, the slots of each pair being parallel and spaced from each other the slots of one pair being orthogonal to the slots of the other pair, the slots of each pair being spaced approximately equidistant from the respective slots of the other pair; forming on a first surface of a second of said planar members two pairs of slots in substantial alignment with the slots on said first planar member; seating cylindrical rods in the slots of said first planar member and placing the second planar member opposite said first planar member with said rods seated in the slots thereof; and repeating the above steps for succeeding planar members to form said assembly.

According to another aspect of the present invention there is provided an aligned assembly when made by the method recited in the preceding paragraph having a cementitious bond between the rods and the respective planar members for maintaining the position of said plates and said rods in said assembly.

The invention is illustrated, merely by way of example, in the accompanying drawings, in which:—

Figure 1 is a plan view of a lens plate of an aligned assembly according to the present invention;

Figure 2 is a cross-section taken along line 2—2 of Figure 1;

Figure 3 is a plan view of a deflector plate of an aligned assembly according to the present invention; and

Figure 4 is a side view of an aligned assembly according to the present invention of the lens plate of Figure 1 and the deflector plates of Figure 3.

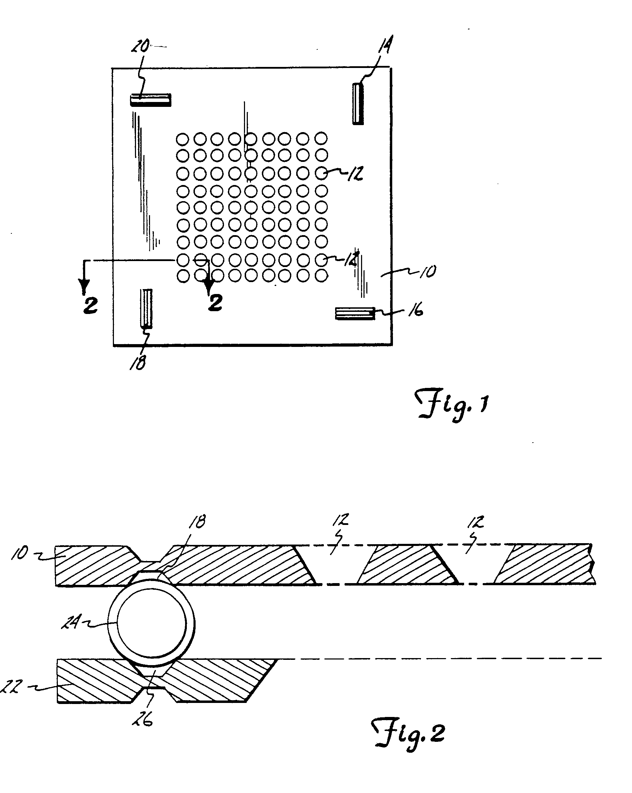

Referring to Figure 1, a lens plate 10 is composed of silicone fabricated from $\langle 100 \rangle$ orientation silicon wafer having a $9 \times 9$ array of circular holes 12 of precise roundness therethrough. The holes are formed by anisotropic etching in a solution of ethylene diaminepyrocatechol-water (EPW) masked by a four micrometer thick boron diffusion layer. The diffusion layer serves as an etch-stop allowing for precision holes to be defined in the four micrometre thick silicon membrane supported by the undercut bulk silicon wafer.

Also etched at the same time as the holes 12 are four rectangular slots 14, 16, 18, 20 which are precision aligned with the array of holes 12. The slots are etched into the plate 10 at the four corners of an imaginary rectangle. The long axis of slots at opposite corners of the rectangle are parallel while the long axis of slots at adjacent corners are orthogonal to each other. This arrangement provides two dimensional stability to the resulting structure as will be understood from the following.

Referring to Figure 2 plates 10 and an identical plate 22 are shown mounted in a spaced and aligned relationship by disposing a cylindrical hollow rod 24 between them. The rod 24 is seated in opposed slots 18, 26 of the two plates. The diameter of the rod 24 and the width of the slot 26 are chosen such that the circumference of the rod 24 rests on the edges of the slots 18, 26 substantially as shown. Were the rod 24 to bottom out on a slot, a freedom of motion would be allowed to that plate as well as an inaccuracy in the spacing between the plates whilst the rod 24 is shown hollow. It will be appreciated that it may be solid.

The rod 24 is preferably composed of a ceramic material that allows the rod to be both lightweight and resistant to high temperatures. The latter requirement becomes more clear when considering the glass bonding technique to be discussed below. The ceramic material also acts as a high voltage insulator between the plates 10, 22.

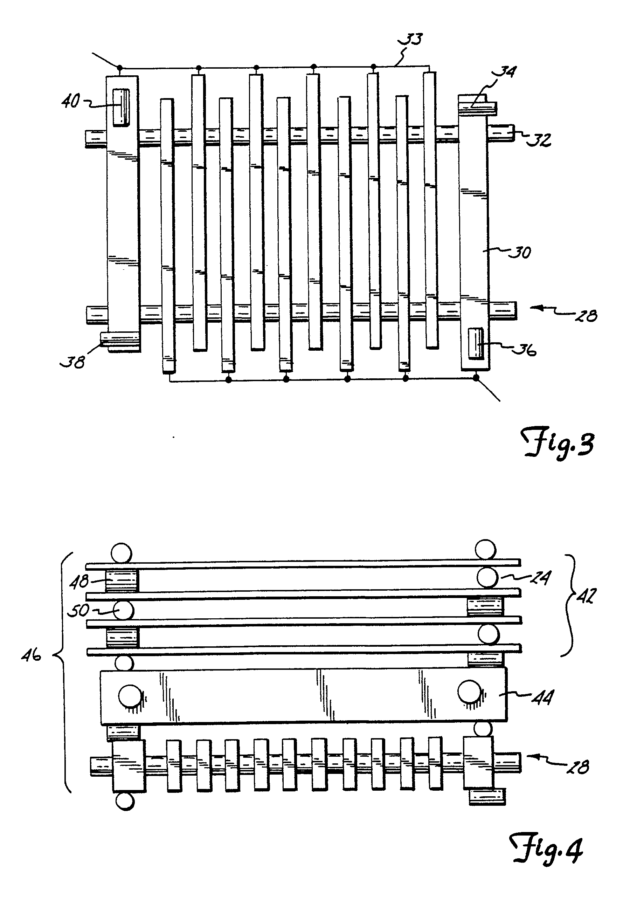

Referring to Figure 3, a parallel blade fine deflector plate 28 is shown. The deflector plate is composed of ten molybdenum deflector blades 30 uniformly spaced and bonded to ceramic rods 32 inserted through holes at opposite ends of each blade and run the width of the deflector plate. Alternate blades 30 are electrically connected together by connectors 33.

Machined into the four corners of the deflector plate 28 are slots 34, 36, 38, 40. These are arranged on the deflector plate 28 and oriented relative to each other as discussed above in relation to the plate 10.

As shown in Figure 4, an aligned assembly 46 according to the present invention comprises a sub-assembly 42 of lens plates and a sub-assembly consisting of the deflector plate 28 and an identical deflector plate 44. The orientation of the cylindrical rods 24 in alternate layers of plates are orthogonal. For instance, a cylindrical rod 48 is oriented at right angles to a cylindrical rod 50 on the layer just immediately below it. This arrangement, while not mandatory, provides an additional source of dimensional stability.

All or part of the aligned assembly 46 may be held together by biasing means, such as springs (not shown), or the plates may be bonded together. A preferred bonding technique uses a cementitious bonding material such as glass powder. In this process the cylindrical rods 24 are inserted into the slots on the respective plates and the structure temporarily held together by a biasing means. A borosilicate glass powder is then inserted into the slots and the structure fired at 1100°C in a nitrogen atmosphere for approximately 15 minutes. The glass powder melts and forms a glass bond at the joint.

It is to be noted that the aligned assembly 46 itself may be mounted on adjoining structure in conventional manner.

**Claims**

1. A method of forming an aligned assembly of a plurality of planar members comprising the steps of: forming on a first surface of a first (10) of said planar members (10, 22) two pairs of slots (14, 16, 18, 20), the slots of each pair being parallel and spaced from each other, the slots of one pair (16, 20) being orthogonal to the slots of the other pair (14, 18), the slots of each pair being spaced approximately equidistant from the respective slots of the other pair; forming on a first surface of a second (22) of said planar members two pairs of slots (26) in substantial alignment with the slots on said first planar member; seating cylindrical rods (24) in the slots of said first planar member and placing the second planar member opposite said first planar member with said rods seated in the slots thereof; and repeating the above steps for succeeding planar members to form said assembly.

2. A method as claimed in claim 1 characterised by including the step of bonding selected planar members together by bonding the cylindrical rods to the slots in which they are seated.

3. A method as claimed in claim 1 or 2 characterised in that at least one of said planar members is composed of silicon and said slots are formed therein by an etching technique.

4. A method as claimed in claim 2 or claim 3 when dependent thereon characterised in that said bonding step comprises applying a glass powder to the joints between said rods and said slots and heating to form a glass bond.

5. A method as claimed in any preceding claim characterised in that said rods are composed of a ceramic material.

6. A method as claimed in any preceding claim characterised by holding said assembly together by mechanical biasing means.

7. A method as claimed in any preceding claim characterised in that each planar member is rectangular, said slots being formed at the corners thereof, a given pair consisting of the diagonally opposed slots.

8. A method as claimed in any preceding claim characterised in that said slots are formed at the corners of an imaginary rectangle.

9. An aligned assembly when made by a method as claimed in any preceding claim characterised by a cementitious bond between the rods and the respective planar members for maintaining the position of said plates and said rods in said assembly.

10. An assembly as claimed in claim 9 characterised in that said cementitious bond is a glass bond.

11. An assembly as claimed in claim 9 or 10 characterised in that there are at least three planar members, the rods between two adjacent planar members being orthogonal to the rods between the two immediately adjacent planar members.

12. An assembly as claimed in claim 11 characterised in that the imaginary rectangles on the surfaces of all planar members are substantially congruent.

13. An assembly as claimed in any of claims 9 to 12 characterised in that said rods are hollow.

**Patentansprüche**

1. Verfahren zur Herstellung einer ausgerichteten Anordnung mehrerer flacher Elemente, das die folgenden Schritte, umfaßt: Ausbilden von zwei Paaren von Schlitzen (14, 16, 18, 20) auf einer ersten Oberfläche eines ersten (10) der flachen Elemente (10, 22) wobei die Schlitze jedes Paares parallel zueinander und mit Abstand voneinander angeordnet und die Schlitze eines Paares (16, 20) senkrecht zu den Schlitzen des anderen Paares (14, 18) angeordnet sind, und wobei die Schlitze jedes Paares einen angenähert gleichen Abstand von den jeweiligen Schlitzen des anderen Paares aufweisen; Ausbilden von zwei Paaren von Schlitzen (26) auf einer ersten Oberfläche eines zweiten (22) der flachen Elemente in im wesentlichen mit den Schlitzen auf dem ersten flachen Element ausgerichteter Form; Einsetzen zylindrischer Stäbe (24) in die Schlitze des ersten flachen Elementes und Anbringen des zweiten flachen Elementes gegenüberliegend zu dem ersten flachen Element, wobei die Stäbe in die Schlitze dieser Elemente eingesetzt sind; und Wiederholen der vorstehenden Schritte für nachfolgenden flache Bauteile zur Bildung der Anordnung.

2. Verfahren nach Anspruch 1, gekennzeichnet durch den Einschluß des Schrittes des Verbindens ausgewählter flacher Elemente miteinander durch Verbinden der zylindrischen Stäbe mit den Schlitzen, in die sie eingesetzt sind.

3. Verfahren nach Anspruch 1 oder 2, dadurch gekennzeichnet, daß zumindestens eines der flachen Elemente aus Silizium besteht und daß die Schlitze in dem flachen Element durch eine Ätztechnik ausgebildet werden.

4. Verfahren nach Anspruch 2 oder 3 unter Rückbeziehung auf diese, dadurch gekennzeichnet, daß der Verbindungsschritt das Aufbringen eines Glaspulvers auf die Verbindungsstellen zwischen den Stäben und den Schlitzen und das Erhitzen zur Bildung einer Glasverbindung umfaßt.

5. Verfahren nach einem der vorhergehenden Ansprüche, dadurch gekennzeichnet, daß die Stäbe aus Keramikmaterial bestehen.

6. Verfahren nach einem der vorhergehenden Ansprüche, dadurch gekennzeichnet, daß die Anordnung durch mechanische Vorspanneinrichtungen zusammengehalten wird.

7. Verfahren nach einem der vorhergehenden Ansprüche, dadurch gekennzeichnet, daß jedes flache Bauteil rechteckig ist, daß die Schlitze an den Ecken des flachen Bauteils ausgebildet sind und daß ein vorgegebenes Paar aus diagonal gegenüberliegenden Schlitzen besteht.

8. Verfahren nach einem der vorhergehenden Ansprüche, dadurch gekennzeichnet, daß die Schlitze an den Ecken eines gedachten Rechteckes ausgebildet sind.

9. Nach einem Verfahren nach einem der vorhergehenden Ansprüche hergestellte ausgerichtete Anordnung, gekennzeichnet durch eine zementitartige Verbindung zwischen den Stäben und den jeweiligen flachen Elementen zur Aufrechterhaltung der Position der flachen Elemente und der Stäbe in der Anordnung.

10. Anordnung nach Anspruch 9, dadurch gekennzeichnet, daß die zementitartige Verbindung eine Glasbindung ist.

11. Anordnung nach Anspruch 9 oder 10, dadurch gekennzeichnet, daß zumindestens drei flache Elemente vorgesehen sind, und daß die Stäbe zwischen zwei benachbarten flachen Elementen senkrecht zu den Stäben zwischen zwei unmittelbar benachbarten flachen Elementen sind.

12. Anordnung nach Anspruch 11, dadurch gekennzeichnet, daß die gedachten Rechtecke auf den Oberflächen aller flachen Elemente im wesentlichen miteinander kongruent sind.

13. Anordnung nach einem der Ansprüche 9 bis 12, dadurch gekennzeichnet, daß die Stäbe hohl sind.

**Revendications**

1. Procédé de formation d'un assemblage aligné comprenant plusieurs organes plans, comportant la formation, sur une première face d'un premier (10) des organes plans (10, 22), de deux paires de fentes (14, 16, 18, 20), les fentes de chaque paire étant parallèles et distantes l'une de l'autre, les fentes d'une première paire (16, 20) étant perpendiculaires à celles de l'autre paire (14, 18), la distance séparant les fentes d'une paire étant sensiblement égale à celle qui sépare les fentes de l'autre paire, la formation, à une première face d'un second (22) des organes plans, de deux paires de fentes (26) sensiblement alignées sur les fentes du premier organe plan, le logement de tiges cylindriques (24) dans les fentes du premier organe plan et la disposition du second organe plan en face du premier, les tiges étant logées dans les fentes, et la répétition des opérations précédentes pour les organes plans successifs afin que l'assemblage soit formé.

2. Procédé selon la revendication 1, caractérisé en ce qu'il comprend la liaison d'organes plans choisis les uns aux autres par liaison des tiges cylindriques aux fentes dans lesquelles elles sont logées.

3. Procédé selon l'une des revendication 1 et 2, caractérisé en ce qu'un organe plan au moins est composé de silicium et les fentes sont formées par une technique d'attaque chimique.

4. Procédé selon la revendication 2 ou la revendication 3, lorsqu'elle dépend de celle-ci, caractérisé en ce que l'opération de liaison comprend l'application d'une poudre de verre aux joints des tiges et des fentes et le chauffage afin qu'une liaison de verre soit formée.

5. Procédé selon l'une quelconque des revendications précédentes, caractérisé en ce que les tiges sont composées d'un matériau céramique.

6. Procédé selon l'une quelconque des revendications précédentes, caractérisé par le maintien de l'assemblage sous forme cohérente par un dispositif mécanique de rappel.

7. Procédé selon l'une quelconque des revendications précédentes, caractérisé en ce que tous les organes plans sont rectangulaires, les fentes étant formées à leurs coins, une paire donnée étant constituée de fentes diagonalement opposées.

8. Procédé selon l'une quelconque des revendications précédentes, caractérisé en ce que les fentes sont formées aux coins d'un rectangle imaginaire.

9. Assemblage aligné, réalisé par le procédé selon l'une quelconque des revendications précédentes, caractérisé par une liaison de collage formée entre les tiges et les organes plans respectifs afin que le positionnement des plaques et des tiges soit conservé dans l'assemblage.

10. Assemblage selon la revendication 9, caractérisé en ce que la liaison par collage est une liaison vitreuse.

11. Assemblage selon l'une des revendications 9 et 10, caractérisé en ce qu'il comprend au moins trois organes plans, les tiges placées entre deux organes plans adjacents étant perpendiculaires aux tiges placées entre deux organes plans immédiatement adjacents.

12. Assemblage selon la revendication 11, caractérisé en ce que les rectangles imaginaires des surfaces de tous les organes plans sont sensiblement superposés.

13. Assemblage selon l'une quelconque des revendications 9 à 12, caractérisé en ce que les tiges sont creuses.

Fig. 1

Fig. 2

Fig.3

Fig.4